# EUROPEAN PATENT APPLICATION

(11) **EP 4 791 128 A1**
(43) Date of publication of application: **12.08.2026**
(21) Application number: 26156812.5
(22) Date of filing: 06.02.2026
(51) Int. Cl.: H05K 7/14, H05K 7/20

(54) **COMBINED POWER AND COOLING SYSTEM DISTRIBUTION PIPING**

(30) Priority: 06.02.2025 US 202563754840 P; 30.01.2026 US 202619465100
(71) Applicant: Vertiv International GmbH, 8212 Neuhausen am Rheinfall (CH)
(72) Inventor: BALMA, Luigi, 40139 Bologna (IT); PECORARI, Stefano, 41121 Modena (IT)
(74) Representative: Beal, James Michael

(57) **Abstract**

An apparatus for distributing electrical power and cooling fluid to a server in a server rack is disclosed. The apparatus includes first and second fluid pipes each formed of an electrically conductive material. The first and second fluid pipes include first and second electrical connections, respectively, of opposite polarities with respect to one another, such that when the first and second fluid pipes are electrically connected to respective ones of first and second electrical connections, the first and second fluid pipes act as first and second electrical terminals for the server. A coolant inlet pipe is configured to convey a non-electrically-conductive cooling fluid into the first fluid pipe. A coolant outlet pipe is configured to convey the cooling fluid from the second fluid pipe. A connecting pipe is configured to convey the cooling fluid from the first fluid pipe to the second fluid pipe, through the server.

## Description

### CROSS-REFERENCE TO RELATED APPLICATIONS

This application claims the benefit of U.S. Provisional Application No. 63/754840, filed on February 6, 2025 and of U.S. Non-Provisional Application No. 19/465100, filed on January 30, 2026.

### TECHNICAL FIELD

This disclosure is directed to mechanisms for distributing power and cooling fluid to server racks.

### BACKGROUND

Information technology (IT) equipment, such as servers, may be housed in racks when implemented in large organizations and facilities such as data centers. Each rack may include one or more servers, as well as power connections, cooling fluid connections, fans, and space for air cooling.

Cooling fluid is typically distributed to a server rack via piping, which carries the cooling fluid to the rack and through the server equipment, where heat is extracted therefrom. The cooling fluid then carries the extracted heat away from the server rack.

Electrical power is typically distributed to a server rack via cabling. Electrical connections are provided on the server rack to connect cables for power and ground, and thus provide an electrical connection to the servers themselves.

### SUMMARY

An apparatus for distributing electrical power and cooling fluid to a server in a server rack. The apparatus combines piping combines piping for cooling fluid with electrical distribution such that they are not separate entities. In one embodiment, an apparatus includes a first electrical terminal of a first polarity. The first electrical terminal comprises a first cooling pipe configured to convey a cooling fluid, the cooling fluid being non-electrically conductive. The apparatus further includes a second electrical terminal of a second polarity opposite of the first polarity, wherein the second electrical terminal comprises a second cooling pipe configured to convey the cooling fluid. The first and second electrical terminals are electrically coupled to provide power to a server, e.g., in a server rack. The apparatus further includes at least one connecting pipe configured to convey the cooling fluid through the server and from the second cooling pipe to the first cooling pipe, a cooling inlet pipe configured to convey the cooling fluid into the second cooling pipe, and a cooling outlet pipe configured to convey the cooling fluid from the first cooling pipe.

### BRIEF DESCRIPTION OF THE DRAWINGS

The above and/or other aspects will become apparent and more readily appreciated from the following description of example embodiments, taken in conjunction with the accompanying drawings, in which:
FIG. 1 is a diagram illustrating an embodiment in which cooling fluid pipes and electrical distribution terminals are combined.
FIG. 2 is a diagram illustrating a cooling system for a server with combined cooling fluid and power distribution pipes.
FIG. 3 is a diagram illustrating an embodiment in which combined cooling piped and power distribution terminals are used to distribute cooling fluid and power to multiple servers.
FIG. 4 is a diagram illustrating another embodiment in which combined cooling piped and power distribution terminals are used to distribute cooling fluid and power to multiple servers.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these example embodiments that are obvious to those of ordinary skill in the technical field to which these example embodiments pertain may not be described herein in detail.

In recent years, the power demand of servers in data centers and other facilities has seen significant increases. This is particularly true with the advent of artificial intelligence (AI) applications. Such applications consume a significant amount of processing power and necessitate the use of growing numbers of cutting edge central processing units (CPUs) and graphics processing units (GPUs). Because of the increased processing demands and corresponding increase in power consumption, power distribution can become a bottleneck, as the current carrying capacity of current mechanisms may be limited.

In addition to the complications of distributing power to servers for AI applications, the amount of heat generated by servers running AI applications also presents a growing problem. Servers are operated within certain thermal limits, that, when exceeded, can cause damage to the equipment. Accordingly, the cooling demands also rise correspondingly with the processing demands. However, the space for piping to carry cooling fluid to the servers may be limited. Furthermore, this space used for cooling fluid piping may be in competition with the space needed for power distribution.

The present disclosure is directed to a mechanism by which the distribution of power and cooling fluid are combined. In particular, the disclosure is directed to combined power distribution and cooling piping. In accordance with the disclosure, cooling piping for a server rack may be made of an electrically conductive material. The cooling system may be arranged such that the cooling fluid comprises a fluid that is not electrically conductive. Furthermore, the exterior of the piping may include electrical connections to which power cabling may be connected. In one embodiment, a first pipe may receive incoming cooling fluid and may also double as a power connection, while a second pipe may provide a path for outgoing cooling fluid and an electrical return path (e.g., a ground connection). Since the piping is made of an electrically conductive material, it may have a large amount of current carrying capacity to allow it to meet the power demands of a server electrically connected thereto.

By combining the distribution of power and cooling fluid using a single structure, namely the piping used to distribute the cooling fluid, significant space savings may be attained relative to implementations where separate and distinct structures are used to distribute power and cooling fluid. As a result of the space savings, more servers, and thus more processing power, may be implemented in a single server rack while still enabling power and cooling distribution needs to be met. Various embodiments of the disclosed cooling and electrical distribution systems are now discussed in further detail.

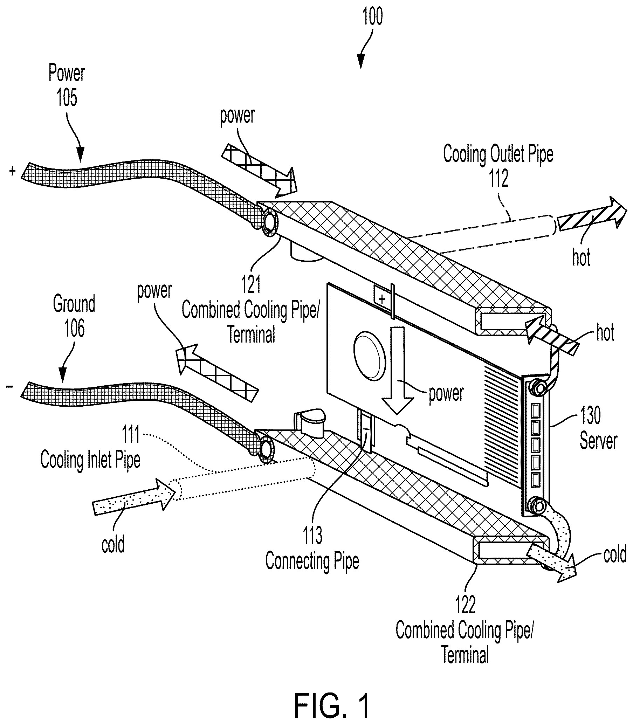

FIG. 1 is a diagram illustrating an embodiment in which cooling fluid pipes and electrical distribution terminals are combined. The example apparatus as shown here may be at least a portion of a server rack that includes one or more server computing systems. For the sake of illustration, the arrangement in accordance with this disclosure is shown for only for a single server system in FIG. 1.

System 100 in the illustrated example includes a server 130 to which power and cooling are provided by combined cooling pipes/terminals 121 and 122. Each of the by combined cooling pipes/terminals 121 and 122 are formed, at least in part, of an electrically conductive material, and may facilitate the flow of a non-electrically-conductive cooling fluid (e.g., demineralized water or other non-electrically-conductive fluid). Combined cooling pipe/terminal 121 is coupled, via power cable 105, to a positive terminal of a DC power source (not shown). Combined cooling pipe/terminal 122 is coupled to a ground terminal of the DC power source. Both of combined cooling pipes/terminals 121 and 122 are in turn electrically coupled to provide power to server 130.

Combined cooling pipes/terminals 121 and 122 are further configured to convey cooling fluid to and from server 130. Combined cooling pipe/terminal 122 is coupled to receive cooling fluid via cooling inlet pipe 111. The cooling fluid may then be conveyed through server 130, via connecting pipe 113, to combined cooling pipe/terminal 121. The cooling fluid, which may enter cold through cooling inlet pipe 111, may extract/absorb heat from server 130 as it passes through. The cooling fluid received by combined cooling pipe/terminal 121 may thus be warmer than that initially received by cooling pipe/electrical terminal 122. The warmer cooling fluid may then be conveyed from the system (e.g., to a heat exchanger) via cooling outlet pipe 112. The power may be delivered to the server 130 towards connecting pipe 113. Some additional power contacts 113B made with conductive springs placed on the two edges of the server 130 in correspondence of the combined cooling pipes/terminals 121 and 122 may increase power capability. The contact surface of the combined cooling pipes/terminals 121 and 122 may allow an arrangement of multiple power contacts 113B all along the server 130 edge this permitting high current flowing through.

In the illustrated example, both combined cooling pipes/terminals 121 and 122 are rectangular shaped. However, the disclosure is not limited to this particular shape for any piping in the system. Furthermore, the various different pipes of the system may be of different shapes with respect to one another.

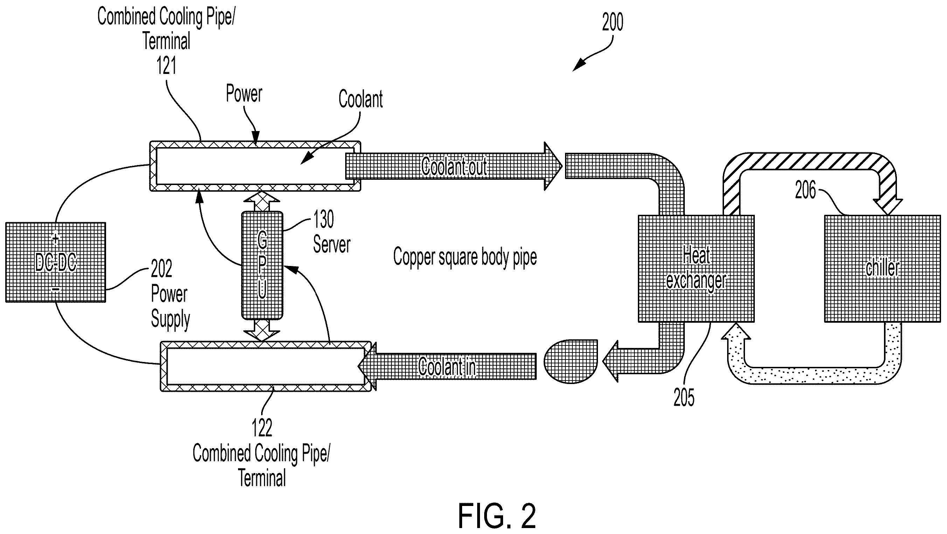

FIG. 2 is a diagram illustrating a cooling system for a server with combined cooling fluid and power distribution pipes. System 200 in the embodiment shown may incorporate various features of system 100 of FIG. 1, and provides additional context regarding the overall power and coolant delivery systems.

Combined cooling pipe/terminal 121 as shown here is arranged to provide cooling fluid to heat exchanger 205, while combined cooling pipe/terminal 122 is configured to receive cooling fluid from heat exchanger 205. Heat is absorbed by the cooling fluid as it passes through server 130, which is discharged to heat exchanger 205. Heat in the cooling fluid received by heat exchanger 205 is in turn absorbed by a refrigerant received form chiller 206. This reduces the temperature of the cooling fluid, which is then provided from heat exchanger 205 back to combined cooling pipe/terminal 122, as the cycle continues.

As shown in FIG. 2, power supply 202 as shown here includes positive and negative terminals that are coupled to cooling pipes/electrical terminals 121 and 122, respectively. Each of cooling pipes/electrical terminals 121 and 122 may be formed in part or in full of an electrically conductive material (e.g., copper). Accordingly, cooling pipes/electrical terminals 121 and 122 act as positive and negative terminals, respectively, for distributing power provided from power supply 202 to server 130. Since elements 121 and 122 act as both cooling pipes and electrical terminals, space savings is achieved relative to arrangements where power and cooling fluid distribution is provided by separate entities.

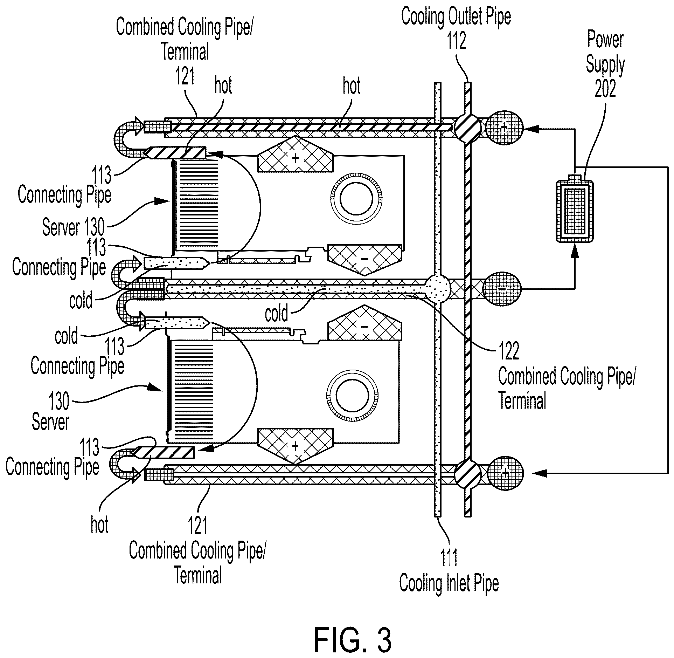

FIG. 3 illustrates another embodiment which may allow for additional space savings. In the embodiment shown, two servers 130 are coupled to receive cooling fluid from combined cooling pipe/terminal 122. Cooling fluid may pass through the servers 130 through corresponding connecting pipes 113 to respective combined cooling pipes/terminals 121. It is noted that in this embodiment, combined cooling pipe/terminal 122 is configured to have a greater capacity for carrying cooling fluid than either of the combined cooling pipes/terminals 121 due to the fact that the former provides cooling fluid for two servers while the latter elements receive cooling fluid from one server each. The circulation of the cooling fluid may otherwise be largely the same as that shown in FIG. 2.

Both of the combined cooling pipes/terminals 121 as shown here act as positive terminals for providing power from power supply 202 to their respective servers 130. In contrast, combined cooling pipe/terminal 122 acts as a negative terminal for both servers in providing a ground/return path to power supply 202. Accordingly, in this arrangement, further space savings is achieved since a singular electrical ground terminal is provided for two different servers 130, while similarly providing a singular inlet for cooling fluid to both servers 130.

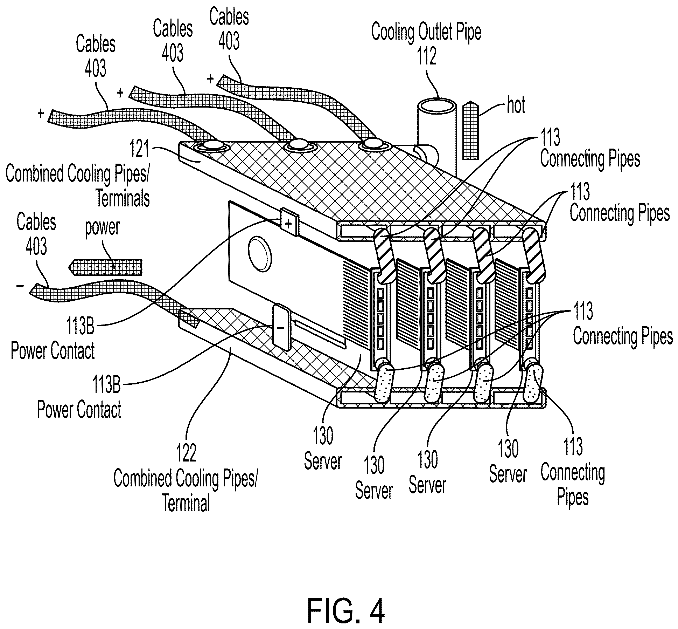

FIG. 4 illustrates another arrangement in accordance with the disclosure. In this embodiment, multiple pipes are combined into corresponding single units for combined cooling pipes/terminals 121 and 122. In this particular example, combined cooling pipes/terminals 121 comprise a single unit subdivided into four pipes, one for each of the four servers 130. Similarly, combined cooling pipes/terminals 122 also comprises a single unit subdivided into four pipes. Each of these single units may be formed in part or in full of an electrically conductive material. Corresponding connecting pipes 113 are also provided to convey cooling fluid to and from the corresponding combined cooling pipes/terminals 121 and 122. Power connections are made via cables 403.

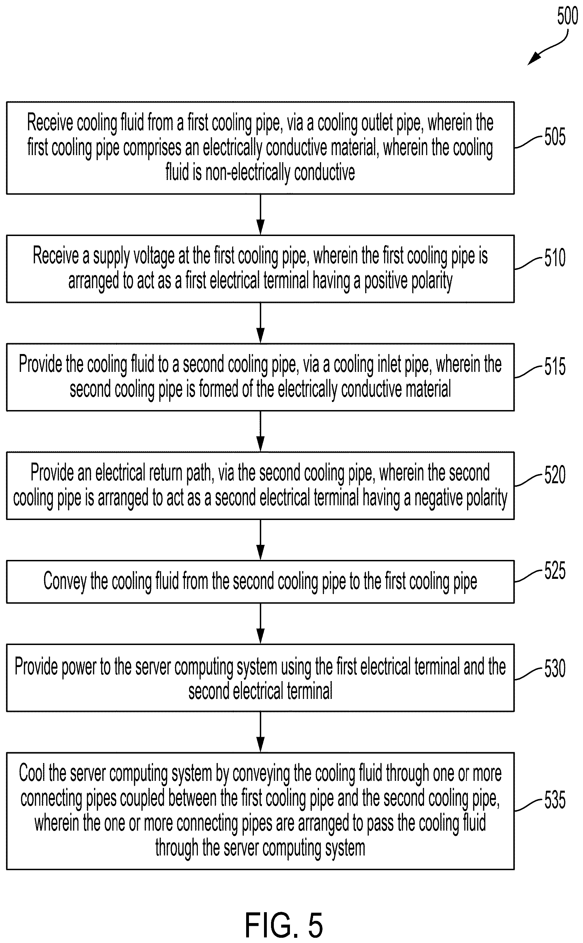

Fig. 5 is a flowchart of an example method 500. In some implementations, one or more process blocks of Fig. 5 may be performed by any of the various apparatus embodiments discussed above.

In the embodiment shown in Fig. 5, method 500 includes receiving cooling fluid from a first cooling pipe, via a cooling outlet pipe, where the first cooling pipe may include an electrically conductive material, where the cooling fluid is non-electrically conductive (block 505). For example, an apparatus may receive cooling fluid from a first cooling pipe, via a cooling outlet pipe, where the first cooling pipe may include an electrically conductive material, where the cooling fluid is non-electrically conductive, as described above.

Method 500 further includes receiving a supply voltage at the first cooling pipe, where the first cooling pipe is arranged to act as a first electrical terminal having a positive polarity (block 510). For example, an embodiment of the apparatus described above may receive a supply voltage at the first cooling pipe, where the first cooling pipe is arranged to act as a first electrical terminal having a positive polarity, as described above.

The method further includes providing the cooling fluid to a second cooling pipe, via a cooling inlet pipe, where the second cooling pipe is formed of the electrically conductive material (block 515). For example, an embodiment of the apparatus described above may provide the cooling fluid to a second cooling pipe, via a cooling inlet pipe, where the second cooling pipe is formed of the electrically conductive material, as described above.

Method 500 further includes providing an electrical return path, via the second cooling pipe, where the second cooling pipe is arranged to act as a second electrical terminal having a negative polarity (block 520). For example, an apparatus in accordance with the disclosure may provide an electrical return path, via the second cooling pipe, where the second cooling pipe is arranged to act as a second electrical terminal having a negative polarity, as described above.

As further shown in Fig. 5, method 500 includes conveying the cooling fluid from the second cooling pipe to the first cooling pipe (block 525). For example, an apparatus embodiment per the discussion above may convey the cooling fluid from the second cooling pipe to the first cooling pipe, as described above.

As also shown in Fig. 5, method 500 includes providing power to the server computing system using the first electrical terminal and the second electrical terminal (block 530). For example, an apparatus of the disclosure may provide power to the server computing system using the first electrical terminal and the second electrical terminal, as described above.

Method 500 further includes cooling the server computing system by conveying the cooling fluid through one or more connecting pipes coupled between the first cooling pipe and the second cooling pipe, where the one or more connecting pipes are arranged to pass the cooling fluid through the server computing system (block 535). For example, the server computer system may be cooled by conveying the cooling fluid through one or more connecting pipes coupled between the first cooling pipe and the second cooling pipe, where the one or more connecting pipes are arranged to pass the cooling fluid through the server computing system, as described above.

It may be understood that the example embodiments described herein may be considered in a descriptive sense only and not for purposes of limitation. Descriptions of features or aspects within each example embodiment may be considered as available for other similar features or aspects in other example embodiments.

While example embodiments have been described with reference to the figures, it will be understood by those of ordinary skill in the art that various changes in form and details may be made therein without departing from the scope as defined by the following claims.

The disclosure comprises the following items:
1. An apparatus for distributing electrical power and cooling fluid to a server in a server rack, the apparatus comprising:
   a first electrical terminal of a first polarity, wherein the first electrical terminal comprises a first cooling pipe configured to convey a cooling fluid, the cooling fluid being non-electrically conductive;
   a second electrical terminal of a second polarity opposite of the first polarity, wherein the second electrical terminal comprises a second cooling pipe configured to convey the cooling fluid, wherein the first and second electrical terminals are electrically coupled to provide power to the server;
   at least one connecting pipe configured to convey the cooling fluid through the server and from the second cooling pipe to the first cooling pipe;
   a cooling inlet pipe configured to convey the cooling fluid into the second cooling pipe; and
   a cooling outlet pipe configured to convey the cooling fluid from the first cooling pipe.
2. The apparatus of item 1, wherein the first cooling pipe and the second cooling pipe are rectangular in shape.
3. The apparatus of item 1 or item 2, wherein the first electrical terminal and the second electrical terminal are formed of an electrically conductive material comprising copper.
4. The apparatus of any preceding item, wherein the at least one connecting pipe, the cooling inlet pipe, and the cooling outlet pipe comprise a non-electrically-conductive material.
5. The apparatus of any preceding item, wherein the cooling fluid comprises demineralized water.
6. The apparatus of any preceding item, further comprising a DC power supply having a positive terminal coupled to the first cooling pipe and a negative terminal coupled to the second cooling pipe.
7. The apparatus of any preceding item, further comprising a heat exchanger configured to receive the cooling fluid as conveyed from the cooling outlet pipe and further configured to convey the cooling fluid to the cooling inlet pipe.
8. The apparatus of any preceding item, further comprising a chiller configured to remove heat from the heat exchanger.
9. The apparatus of any preceding item, wherein the first electrical terminal comprises a first plurality of cooling pipes, including the first cooling pipe, arranged in parallel, and wherein the second electrical terminal comprises a second plurality of cooling pipes, including the second cooling pipe, arranged in parallel, wherein the cooling inlet pipe is configured to convey the cooling fluid into the second plurality of cooling pipes, and wherein the cooling outlet pipe is configured to convey the cooling fluid from the first plurality of cooling pipes.
10. An apparatus for distributing electrical power and cooling fluid to a server in a server rack, the apparatus comprising:
   a first fluid pipe and a second fluid pipe each comprising an electrically conductive material, wherein the first fluid pipe includes a first electrical connection of a first polarity, and wherein the second fluid pipe includes a second electrical connection of a second polarity opposite the first polarity such that, when both the first fluid pipe and second fluid pipe are electrically connected to a respective one of the first electrical connection and the second electrical connection, the first fluid pipe and second fluid pipe act as a first electrical terminal and a second electrical terminal, respectively, for the server in the server rack;
   a coolant inlet pipe configured to convey a cooling fluid into the first fluid pipe, the cooling fluid being non-electrically conductive;
   a coolant outlet pipe configured to convey the cooling fluid from the second fluid pipe; and
   a connecting pipe configured to convey the cooling fluid from the first fluid pipe to the second fluid pipe, wherein the connecting pipe is arranged to pass through the server.
11. The apparatus of item 10, wherein the electrically conductive material of the first fluid pipe and the second fluid pipe comprises copper, and wherein the connecting pipe, the coolant inlet pipe, and the coolant outlet pipe comprise a non-electrically conductive material.
12. The apparatus of item 10 or item 11, further comprising a DC power supply having a positive terminal coupled to the first electrical connection on the first fluid pipe and a negative terminal coupled to the second electrical connection on the second fluid pipe.
13. The apparatus of any of items 10-12, wherein the first fluid pipe comprises a first plurality of parallel fluid sub-pipes, and the second fluid pipe comprises a second plurality of parallel fluid sub-pipes, the coolant inlet pipe being configured to convey the cooling fluid into the second plurality and the coolant outlet pipe being configured to convey the cooling fluid from the first plurality.
14. The apparatus of any of items 10-13, further comprising:
   a heat exchanger configured to receive the cooling fluid conveyed from the coolant outlet pipe and to provide the cooling fluid to the coolant inlet pipe; and
   a chiller configured to remove heat from the heat exchanger.
15. The apparatus of any of items 10-14, wherein the first fluid pipe and the second fluid pipe are rectangular in cross-sectional shape.
16. The apparatus of any of items 10-15, wherein the cooling fluid comprises demineralized water.
17. A method for providing power and cooling to a server computing system, the method comprising:
   receiving cooling fluid from a first cooling pipe, via a cooling outlet pipe, wherein the first cooling pipe comprises an electrically conductive material, wherein the cooling fluid is non-electrically conductive;
   receiving a supply voltage at the first cooling pipe, wherein the first cooling pipe is arranged to act as a first electrical terminal having a positive polarity;
   providing the cooling fluid to a second cooling pipe, via a cooling inlet pipe, wherein the second cooling pipe is formed of the electrically conductive material;
   providing an electrical return path, via the second cooling pipe, wherein the second cooling pipe is arranged to act as a second electrical terminal having a negative polarity;
   conveying the cooling fluid from the second cooling pipe to the first cooling pipe;
   providing power to the server computing system using the first electrical terminal and the second electrical terminal; and
   cooling the server computing system by conveying the cooling fluid through one or more connecting pipes coupled between the first cooling pipe and the second cooling pipe, wherein the one or more connecting pipes are arranged to pass the cooling fluid through the server computing system.
18. The method of item 17, further comprising supplying a DC voltage to the first cooling pipe from a DC power supply such that the first cooling pipe has a positive polarity and the second cooling pipe provides an electrical return path having a negative polarity.
19. The method of item 17 or item 18, further comprising conveying the cooling fluid from the cooling outlet pipe to a heat exchanger and returning the cooling fluid from the heat exchanger to the cooling inlet pipe.
20. The method of any of items 17-19, further comprising removing heat, using a chiller, from the heat exchanger.

## Claims

1. An apparatus for distributing electrical power and cooling fluid to a server in a server rack, the apparatus comprising:
a first electrical terminal of a first polarity, wherein the first electrical terminal comprises a first cooling pipe configured to convey a cooling fluid, the cooling fluid being non-electrically conductive;
a second electrical terminal of a second polarity opposite of the first polarity, wherein the second electrical terminal comprises a second cooling pipe configured to convey the cooling fluid, wherein the first and second electrical terminals are electrically coupled to provide power to the server;
at least one connecting pipe configured to convey the cooling fluid through the server and from the second cooling pipe to the first cooling pipe;
a cooling inlet pipe configured to convey the cooling fluid into the second cooling pipe; and
a cooling outlet pipe configured to convey the cooling fluid from the first cooling pipe.

2. The apparatus of claim 1, wherein the first cooling pipe and the second cooling pipe are rectangular in shape.

3. The apparatus of claim 1 or claim 2, wherein the first electrical terminal and the second electrical terminal are formed of an electrically conductive material comprising copper.

4. The apparatus of any preceding claim, wherein the at least one connecting pipe, the cooling inlet pipe, and the cooling outlet pipe comprise a non-electrically-conductive material.

5. The apparatus of any preceding claim, wherein the cooling fluid comprises demineralized water.

6. The apparatus of any preceding claim, further comprising a DC power supply having a positive terminal coupled to the first cooling pipe and a negative terminal coupled to the second cooling pipe.

7. The apparatus of any preceding claim, further comprising a heat exchanger configured to receive the cooling fluid as conveyed from the cooling outlet pipe and further configured to convey the cooling fluid to the cooling inlet pipe.

8. The apparatus of claim 7, further comprising a chiller configured to remove heat from the heat exchanger.

9. The apparatus of any preceding claim, wherein the first electrical terminal comprises a first plurality of cooling pipes, including the first cooling pipe, arranged in parallel, and wherein the second electrical terminal comprises a second plurality of cooling pipes, including the second cooling pipe, arranged in parallel, wherein the cooling inlet pipe is configured to convey the cooling fluid into the second plurality of cooling pipes, and wherein the cooling outlet pipe is configured to convey the cooling fluid from the first plurality of cooling pipes.

10. A method for providing power and cooling to a server computing system, the method comprising:
receiving cooling fluid from a first cooling pipe, via a cooling outlet pipe, wherein the first cooling pipe comprises an electrically conductive material, wherein the cooling fluid is non-electrically conductive;
receiving a supply voltage at the first cooling pipe, wherein the first cooling pipe is arranged to act as a first electrical terminal having a positive polarity;
providing the cooling fluid to a second cooling pipe, via a cooling inlet pipe, wherein the second cooling pipe is formed of the electrically conductive material;
providing an electrical return path, via the second cooling pipe, wherein the second cooling pipe is arranged to act as a second electrical terminal having a negative polarity;
conveying the cooling fluid from the second cooling pipe to the first cooling pipe;
providing power to the server computing system using the first electrical terminal and the second electrical terminal; and
cooling the server computing system by conveying the cooling fluid through one or more connecting pipes coupled between the first cooling pipe and the second cooling pipe, wherein the one or more connecting pipes are arranged to pass the cooling fluid through the server computing system.

11. The method of claim 10, further comprising supplying a DC voltage to the first cooling pipe from a DC power supply such that the first cooling pipe has a positive polarity and the second cooling pipe provides an electrical return path having a negative polarity.

12. The method of claim 10 or claim 11, further comprising conveying the cooling fluid from the cooling outlet pipe to a heat exchanger and returning the cooling fluid from the heat exchanger to the cooling inlet pipe.

13. The method of claim 12, further comprising removing heat, using a chiller, from the heat exchanger.
